# EUROPEAN PATENT APPLICATION

(11) **EP 2 983 296 A1**
(43) Date of publication of application: **10.02.2016**
(21) Application number: 14795481.2
(22) Date of filing: 03.04.2014
(51) Int. Cl.: H03M 3/00

(54) **DELTA SIGMA MODULATOR AND MODULATION METHOD THEREOF**

(30) Priority: 07.05.2013 CN 201310166080
(71) Applicant: ZTE Corporation, Shenzhen, Guangdong 518057 (CN)
(72) Inventor: DONG, Peng, Shenzhen Guangdong 518057 (CN); LIAO, Hongyin, Shenzhen Guangdong 518057 (CN)
(74) Representative: Awapatent AB
(86) International application number: PCT/CN2014/074752
(87) International publication number: WO 2014/180202

(57) **Abstract**

A delta sigma modulator (DSM) and a method for the DSM performing modulation, wherein, the method includes: pre-processing inputted data; predicting a DSM modulation result according to the current data; finally, performing a DSM modulation on the current data according to the pre-processed data and the prediction result. An embodiment of the present invention pre-processes the inputted data and predicts a DSM modulation result so as to realize a multistage pipeline register structure in DSM, thus improving timing sequences of key sections such as adders without affecting characteristics of an original transfer function, thereby increasing sampling frequency of circuit operations and improving SNR performance.

## Description

### Technical Field

The embodiment of the present invention relates to a delta sigma modulator and a method for the DSM performing modulation.

### Background of the Invention

Delta Sigma Modulator (wherein Delta Sigma represents delta-sigma) is hereinafter referred to as DSM. The DSM uses oversampling (i.e., the sampling rate is many times higher compared to the signal bandwidth) and noise shaping technology (i.e., quantization noise is mainly distributed outside the band and the in-band noise is low), and is able to modulate a multi-bit input signal into an output signal of few bits or even a single bit, meanwhile, it can maintain the signal to noise ratio (SNR) performance of the signal. Because the DSM can convert a multi-bit non-constant envelope signal into a single-bit constant envelope signal, in case that the DSM and high power amplifiers can be used together, the efficiency of the power amplifiers can be greatly improved.

In the past few decades, the DSM has been widely used in the audio field due to the low bandwidth of audio signals, so the DSM implementation requires a very low sampling rate. In recent years, along with the development of 3G and 4G technologies in the field of communication, in order to improve the efficiency of the transmitter, expectations for DSM applications in the field of communication are increasingly high.

The biggest challenge met by the DSM applications in the field of high-speed data processing such as the field of communication comes from the sampling frequency. Because the bandwidth of communications signals is very wide, the communication signal has a bandwidth of several or even tens of MHz, while the audio signal has a bandwidth of several thousand hertz (Hz). Since the DSM uses the oversampling technology, the higher the oversampling rate, the better SNR performance of the output signal, therefore, for high-bandwidth signal in communication, in order to ensure that the SNR performance of the output, the DSM is required to work at a higher sampling frequency.

For digital transmitters, DSM circuits are typically implemented with digital circuits, and are typically implemented with Field Programmable Gate Arrays (FPGA) or Integrated Circuits (ICs). The working clock of the FPGA circuits is below 400MHz, and the IC circuits can reach around 1GHz through the gate-level optimization. However, due to the presence of feedback loop in the DSM circuit, it is impossible to optimize the circuit timing by commonly adding pipeline registers, therefore, it is a very difficult thing for the FPGA and IC circuits to improve the SNR performance of the DSM by increasing the sampling frequency.

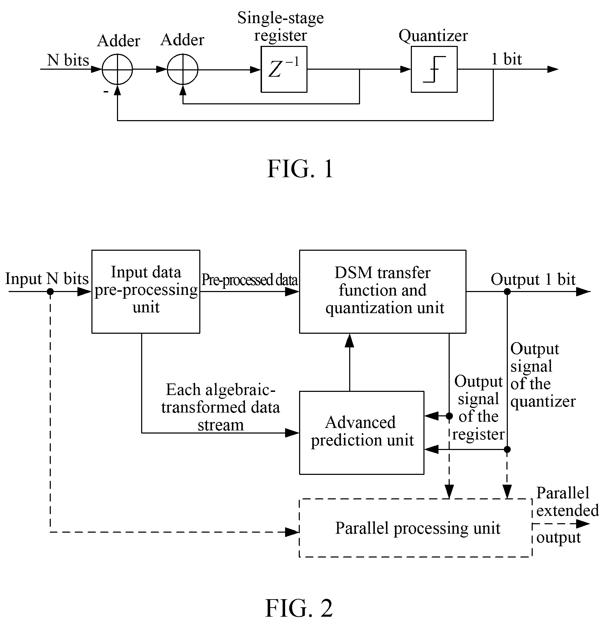

FIG. 1 is a schematic diagram of the structure of a conventional DSM, and as shown in FIG. 1, the conventional DSM structure's transfer function has many adders, and these adders usually only has one pipeline register as an output, therefore, key sections affecting the circuit timing converge on the adders in the circuit implementation, thus affecting the working performance of the entire circuit. Simply adding the pipeline register into the circuit can change the transfer function of the entire feedback loop and make it impossible to achieve the original functions.

In order to achieve a DSM circuit with high performance in communication, there are generally two solutions in the industry: one is using analog circuits to accomplish functions of the DSM circuit, which is often used by a variety of analog/digital converter (ADC) devices. However, for the structure of a transmitter used in communication, because what are processed are digital signals, such DSM is not applicable. The other is using some digital methods such as polyphase decomposition and time interleaving to optimize and increasing the sampling rate through a parallel way, but this parallel way makes the circuit structure more complicated, so that the operating speed is affected, and is very difficult to achieve.

Related patent documents comprise: the CN patent application "audio generating apparatus with a delta-sigma modulation architecture and method thereof" with the patent application number CN201010230424.9, and the US Patent "Parallel Time Interleaved Delta Sigma Modulator" with the Patent No. US6518905B2. Wherein, the CN Patent Application No. 201010230424.9 has the following deficiencies: this patent is only for general analog or low-speed circuit design, and did not specify implementation methods under high-speed sampling frequency, and cannot be applied to high-speed sampling frequency design scenarios. The patent application No. US6518905B2 has the following deficiencies: the embodiments of this invention use multiple DSM parallel branches to simultaneously perform continuous DSM processing on the analog input signal, then sample it with clocks of different phases, and recover it to data with high-speed sampling rate to output. This method is only suitable for analog circuits, and cannot be used in digital circuits as well as transmitter structures.

### Summary of the Invention

The embodiment of the present invention provides a Delta Sigma modulator (DSM) and a method for the DSM performing modulation to increase the sampling rate of a DSM, thus improving SNR performance of the DSM, and ensuring DSM applications in the field of high-speed data processing.

To solve the abovementioned technical problem, the embodiment of the present invention discloses a Delta Sigma Modulator (DSM), comprising an input data pre-processing unit, a DSM transfer function and quantization unit, and an advanced prediction unit, wherein,
the input data pre-processing unit is configured to: pre-process input data, output the pre-processed data to the DSM transfer function and quantization unit, and output each intermediate-algebraic-transformed data stream to the advanced prediction unit;
the DSM transfer function and quantization unit is configured to: receive data from the input data pre-processing unit and the advanced prediction unit, and perform the DSM function on the received data;
the advanced prediction unit is configured to: receive each intermediate-algebraic-transformed data stream from the input data pre-processing unit as well as data output from a register and a quantizer of the DSM transfer function and quantization unit; and according to the currently received data, predict an output value of the quantizer of the DSM transfer function and quantization unit ahead of time, and feed the output value back to the DSM transfer function and quantization unit.

The DSM further comprises a parallel processing unit, configured to: receive the input data as well as the data output from the register and the quantizer of the DSM transfer function and quantization unit; process the received data in parallel to obtain parallel outputs.

One is subtracted from a number of the intermediate-algebraic-transformed data streams and a number of stages of the input data respectively.

The DSM transfer function and quantization unit comprises adders, a multi-stage pipeline register, and a quantizer.

The input data are single-stage data, and the multi-stage pipeline register is a one-stage pipeline register;
or, the input data are multi-stage data, a number of stages of the multi-stage pipeline register is the same as the number of stages of the input data.

One is subtracted from the number of paths of the intermediate-algebraic-transformed data streams and the number of stages of the input data respectively;
the DSM transfer function and quantization unit comprises adders, a multi-stage pipeline register, and a quantizer;
the input data are a plurality of parallel multi-stage data streams, the multi-stage pipeline register is a pipeline register in a first branch, and data currently output by the multi-stage pipeline register are taken as a first parallel branch;
the parallel processing unit processes in parallel to obtain M-1 parallel branches, wherein M is a number of parallel branches;

Wherein, a number of stages of the pipeline in each branch is: a result of the number of stages of the input data N being divided by the number of parallel branches M.

A finite impulse response (FIR) filter is provided in the input data pre-processing unit.

The DSM is of a first-stage structure, or a two-stage structure, or three-stage or more than three-stage structure.

The embodiment of the present invention further provides a method for a Delta Sigma modulator performing modulation, comprising:

Pre-processing input data; predicting a DSM modulation result according to current data;
performing a DSM modulation on the current data according to the pre-processed data and the prediction result.

Said predicting a DSM modulation result according to current data is: predicting an output value of a quantizer in the DSM ahead of time according to data output from a register and a quantizer in the DSM as well as each intermediate-algebraic-transformed data stream during the pre-processing, and feeding the output value back to the DSM.

One is subtracted from a number of the intermediate-algebraic-transformed data streams and a number of stages of the input data respectively.

The pre-processing comprises: FIR processing, delay and allocation processing.

The input data are single-stage data, a DSM modulation mode is a traditional DSM modulation mode.

The input data are a multi-stage data; a number of stages of a multi-stage pipeline register in the DSM modulation is the same as the number of stages of the input data; and,

Both the preprocessing and the prediction comprise multi-stage processing.

The input data are a plurality of parallel multi-stage data streams; the method further comprises: processing the data output from the register and the quantizer in the DSM as well as the input data in parallel;
the multi-stage pipeline register in the DSM modulation is a pipeline register in a first branch, data currently output by the multi-stage pipeline register are taken as a first parallel branch; M-1 parallel branches are obtained through processing in parallel, wherein M is a number of parallel branches;
wherein, a number of stages of the pipeline in each branch is: a result of the number of stages of the input data N being divided by the number of parallel branches M.

The technical scheme of the present application comprises: pre-processing inputted data; predicting a DSM modulation result according to the current data; finally, performing a DSM modulation on the current data according to the pre-processed data and the prediction result. An embodiment of the present invention pre-processes the inputted data and predicts the DSM modulation result, and achieves a multistage pipeline register structure in the DSM, thus improving the timing sequences of key sections such as the adders without affecting the characteristics of the original transfer function, thereby increasing the sampling frequency of circuit operations and thus improving the SNR performance.

The embodiment of the present invention makes the DSM provided in the embodiment of the present invention support parallel data modulation through parallel processing, and also achieves higher sampling frequency, greatly increases the DSM sampling rate and improves the SNR performance of the DSM on the basis of achieving the multi-stage pipeline register structure in the DSM, thus better ensuring the DSM applications in the field of high-speed data processing.

### Brief Description of the Drawings

The accompanying drawings are used to provide a further understanding of the embodiments of the present invention and form a part of the present application, exemplary embodiments of the present invention and their explanations are used to explain the present invention and do not constitute an improper limitation on the embodiments of the present invention. In the accompanying drawings:
FIG. 1 is a schematic diagram of a conventional DSM structure;
FIG. 2 is a schematic diagram of a DSM structure in accordance with an embodiment of the present invention;
FIG. 3 a schematic diagram of the structure of an embodiment for achieving a DSM high-speed pipeline processing apparatus in accordance with an embodiment of the present invention;
FIG. 4 is a schematic diagram of a circuit structure after the embodiment of the DSM high-speed pipeline processing apparatus in FIG. 3 optimizes the timing in accordance with an embodiment of the present invention;
FIG. 5 is a schematic diagram of the structure of the embodiment of the input data preprocessing unit and the advanced prediction unit in FIG. 4 in accordance with an embodiment of the present invention;
FIG. 6 is a schematic diagram of the structure of an embodiment for achieving the DSM high-speed pipelined parallel processing apparatus in accordance with an embodiment of the present invention;
FIG. 7 is a schematic diagram of the structure of the embodiment of the input data preprocessing unit and advanced prediction unit in FIG. 6 in accordance with an embodiment of the present invention;
FIG. 8 is a flow chart of a method for achieving a DSM modulation in accordance with an embodiment of the present invention.

### Preferred Embodiments of the Invention

FIG. 2 is a schematic diagram of a DSM structure in accordance with an embodiment of the present invention, as shown in FIG. 2, comprising an input data pre-processing unit, a DSM transfer function and quantization unit, and an advanced prediction unit, wherein,
the input data pre-processing unit is configured to: pre-process input data, such as perform Finite Impulse Response filter (FIR) processing on input data, as well as perform treatments such as delaying and distribution (such as algebraic combinatoric and mathematical transformation, that is, output after the algebraic transformation) on the input data, and output the processed data to the DSM transfer function and quantization unit, and output each intermediate-algebraic-transformed data stream to the advanced prediction unit.

Through the processing by the input data pre-processing unit according to the embodiment of the present invention, the input data produces a change from Z⁻¹ to Z^{-N} (N represents the number of stages, meanwhile, N also corresponds to the number of stages of the multi-stage pipeline in the DSM transfer function and quantization unit), that is to say, it provides a basis for the multi-stage realization of the DSM transfer function and quantization unit. Wherein, one is subtracted from the number of the intermediate-algebraic-transformed data streams and the number of stages of the input data respectively.

The DSM transfer function and quantization unit is configured to: receive data from the input data pre-processing unit and the advanced prediction unit, perform the DSM function on the received data. The DSM transfer function and quantization unit consists of adders, a multi-stage pipeline register, and a quantizer, and it may be one, two or more stages. The difference between the DSM transfer function and quantization unit in the embodiment of the present invention and the traditional DSM processing module is that: the transfer function of the DSM transfer function and quantization unit in accordance with the embodiment of the present invention has a multi-stage pipeline register structure, however, from the point of view of the entire system, the characteristics of the transfer function remain unchanged and are not affected by the timing optimization.

The advanced prediction unit is configured to: receive data from the input data pre-processing unit and the DSM transfer function and quantization unit, predict an output value of the quantizer ahead of time according to the currently received data, and feed and output it to the DSM transfer function and quantization unit. Wherein, the data from the DSM transfer function and quantizing unit comprise data output from the register and the quantizer therein.

Through the processing carried out by the advanced prediction unit in the embodiment of the present invention, on the one hand, the data signal is corrected; and on the other hand, the input data produces a change from Z⁻¹ to Z^{-N}, that is, the advanced prediction unit and the input data pre-processing unit in the embodiment of the present invention cooperate to provide a guarantee for the achievement of the multi-stage pipeline structure of the DSM transfer function and quantization unit.

The input data pre-processing unit, the DSM transfer function and quantization unit, and the advanced prediction unit in the embodiment of the present invention are collectively referred to as DSM high-speed pipeline processing apparatus. The DSM high-speed pipeline processing apparatus according to the embodiment of the present invention achieves the multi-stage pipeline register structure in the DSM through the input data pre-processing unit and the advanced prediction unit, so as to improve the timing of key sections such as the adders without affecting the characteristics of the original transfer function, thereby increasing the sampling frequency of the circuit operations and improving the SNR performance.

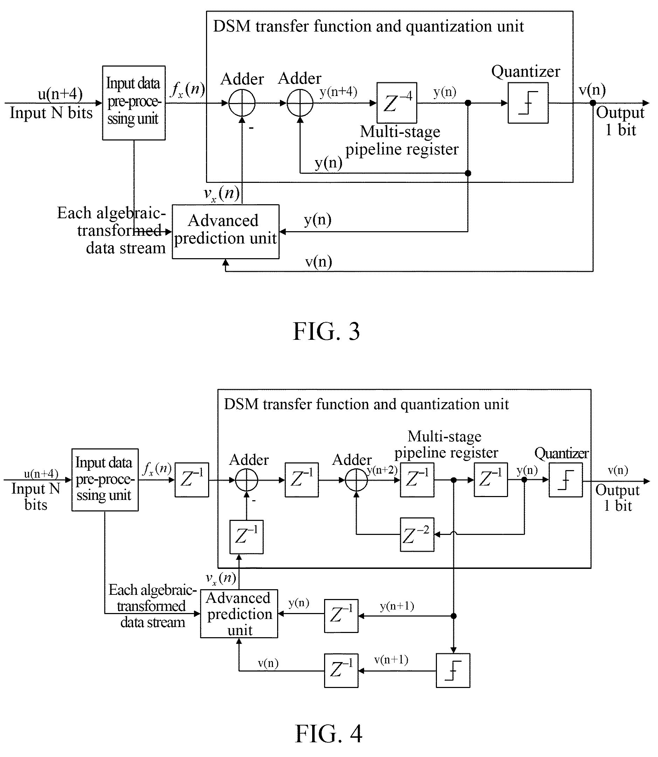

FIG. 3 a schematic diagram of the structure of an embodiment for achieving the DSM high-speed pipeline processing apparatus in accordance with an embodiment of the present invention, the present invention takes N = 4-stage pipeline as an example, as shown in FIG. 3,
the input data u(n+4) is first processed by the input data pre-processing unit, such as processed through the equivalent FIR processing and delay processing, to obtain fₓ(n) and output it to the DSM transfer function and quantization unit, at the same time, each intermediate-algebraic-transformed data stream is output to the advance prediction unit, and N=4 is taken as an example in the present embodiment, and there are (N-1)=3 intermediate-algebraic-transformed data streams;
the advanced prediction unit receives each intermediate-algebraic-transformed data stream from the input data pre-processing unit, as well as y(n) output by the multi-stage pipeline register and v(n) output from the quantizer which are fed back by the DSM transfer function and quantization unit, and predicts the output value vₓ(n) of the quantizer ahead of time based on the signal state of the currently received data, and feeds and outputs it to the input end of the DSM transfer function and quantization unit;

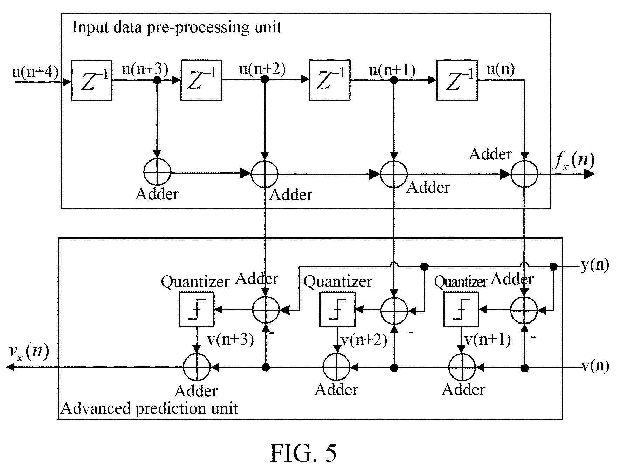

Due to the presence of the input data pre-processing unit and the advanced prediction unit (the implementation method is described in detail in FIG. 5), the input data produces a change from Z⁻¹ to Z⁻⁴, therefore, the register has a multi-stage pipeline structure in the circuit contained in the DSM transfer function and quantization unit, which provides preconditions for achieving the timing optimization.

On the basis of the structure of the DSM high-speed pipeline processing apparatus shown in FIG. 3, through equivalent circuit conversion, a person skilled in the field can easily obtain an circuit structure of a timing-optimized DSM high-speed pipeline processing unit, as shown in FIG. 4, in the circuit included in the DSM transfer function and quantization unit, the four-stage pipeline of the multi-stage pipeline register is distributed at various locations, such as the path between the adder and the quantizer, the path between the adders, the path between the adder and the input data pre-processing unit in the DSM high-speed pipeline processing unit, and the path between the adder and the advanced prediction unit in the DSM high-speed pipeline processing unit. Thus, undoubtedly it is equivalent to adding a multi-stage pipeline in the circuit, thus greatly improving the operating speed of the circuit.

The circuit configuration of the input data pre-processing unit and the advanced prediction unit in FIG. 3 and FIG. 4 is as shown in FIG. 5, the input data pre-processing unit comprises a multi-stage register and adders and is essentially equivalent to a FIR filter structure of input signal, so it is very suitable to be inserted into the pipeline register for timing optimization and will not affect the operating speed of the circuit. The data pre-processing unit has many realizations which belong to conventional techniques used by those skilled in the art, and FIG. 5 is merely illustrative and is not intended to limit the protection scope of the embodiments of the present invention.

When achieving according to the actual circuit, as shown in FIG. 5, the advanced prediction unit comprises a plurality of single-bit quantizers and adders which have many realizations which belong to conventional techniques used by those skilled in the art, FIG. 5 is merely illustrative and is not intended to limit the protection scope of the embodiments of the present invention. The circuit shown in FIG. 5 is relatively complex, so it can be equivalent to a look-up table structure in accordance with the input and output relationship, and the presence of the single-bit quantizers makes the desired look-up table input bit width very small, which also guarantees that the scale of the look-up table is in the achievable range. As seen in FIG. 5, both the input and output ends of the advanced prediction unit have pipeline registers, so it also ensures that the timing of this structure is very good and does not affect the overall operating speed of the circuit.

As seen from the circuit structure shown in FIG. 5, the overall operating speed of the structure of the DSM high-speed pipeline processing apparatus shown in FIG. 4 is very high, thus ensuring that the DSM can work at a very high sampling rate, which is ideal for integrated circuit (IC) implementation.

As shown in FIG. 2, the DSM in the embodiment of the present invention further comprises a parallel processing unit, configured to: extend the DSM high-speed pipeline processing apparatus to a DSM high-speed pipeline parallel processing apparatus.

The parallel processing unit receives input data, as well as data from the DSM transfer function and quantization unit, and performs parallel processing on it to obtain parallel output. Wherein, the data from the DSM transfer function and quantizing unit comprise data output from the register and the quantizer therein.

The DSM high-speed pipelined parallel processing unit which is added with the parallel processing unit takes the data currently output from the DSM high-speed pipeline processing apparatus as the first parallel branch, and computes out the signal states of the output data in the other (M-1) parallel branches in accordance with the signal state of the output data in the first parallel branch, wherein M represents the number of parallel branches, so as to achieve that the input data are allowed to be M-branch parallel data, and the parallel processing unit can be used to extend the single-branch output to M-branch parallel output. In other words, the work sampling frequency of the single-branch DSM is Fs, then, the structure of the DSM high-speed pipeline parallel processing apparatus provided in the embodiment of the present invention also achieves a higher sampling frequency, namely M*Fs, on the basis of achieving the multi-stage pipeline register structure in the DSM, thus greatly increasing the DSM sampling rate, improving the SNR performance of the DSM, and better guaranteeing the DSM applications in the field of high-speed data processing.

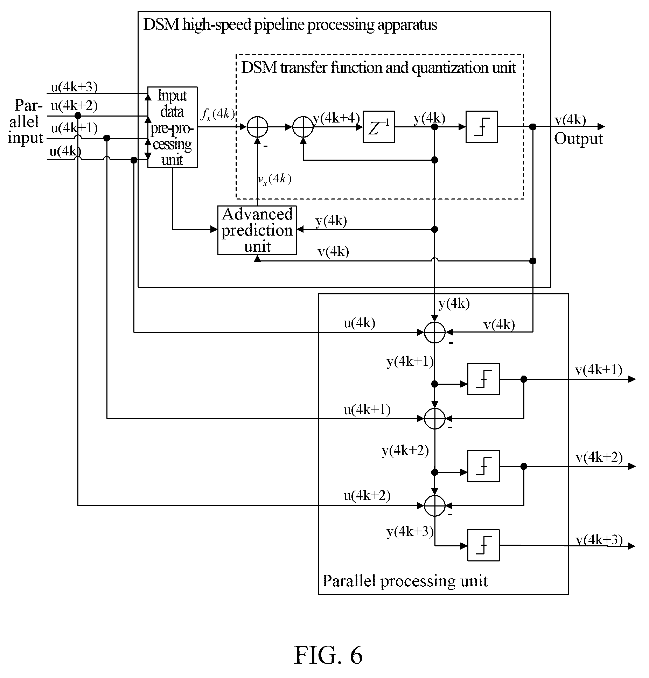

FIG. 6 is a schematic diagram of the structure of an embodiment for achieving the DSM high-speed pipelined parallel processing apparatus in accordance with an embodiment of the present invention, and the present embodiment takes a pipeline whose number of stages is N=4, and parallel branch data whose number of parallel branches is M=4 for example, as shown in FIG. 6, compared with the circuit shown in FIG. 3, the input signal is changed from a single transmitted data flow to 4 parallel data flows, the 4-stage pipeline register in the circuit contained in the DSM transfer function and quantization unit works as the pipeline register in the first branch, and then a parallel processing unit is added.

In FIG. 6, the data v (4k) output by the DSM transfer function and quantization unit is the first branch of the parallel data flow, and the parallel processing unit extends the current data obtained from the DSM high-speed pipeline processing apparatus to obtain data in the other three branches of the parallel data flow, shown as v(4k + 1), v(4k + 2) and v(4k + 3) in FIG. 6, so as to form a complete parallel output data flow.

As shown in FIG. 6, the input data of the parallel processing unit respectively come from the outputs of the register and the quantizer of the DSM transfer function and quantization unit, as well as the four parallel input signals of the originally input data, and it can be seen that the data flow is unidirectional, therefore, it is ideally suitable to be inserted into the pipeline registers optimize, thereby increasing the operating speed of the circuit.

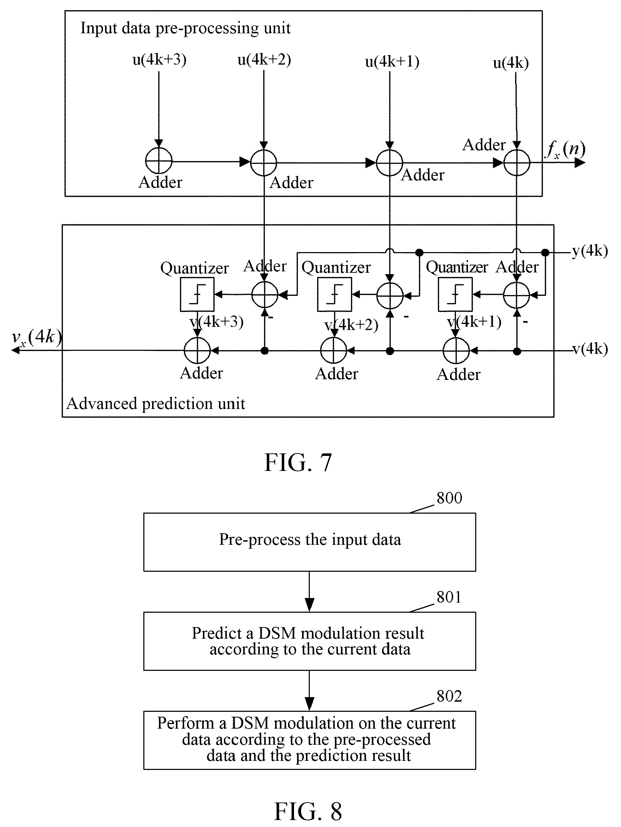

The circuit structure of the input data pre-processing unit and the advanced prediction unit in FIG. 6 is shown in FIG. 7, and compared with FIG. 5, the data input by the pre-processing unit in FIG. 7 change to parallel signal flows, and other structures are the same, for those skilled in the art, the implementation ways are conventional techniques and are not intended to limit the protection scope of the embodiments of the present invention, and are not further repeated here.

From the structures schematically shown in FIG. 2 to FIG. 7, it can be seen that,
when the input data are of single-stage, the multi-stage pipeline register in the DSM in the embodiment of the present invention is a one-stage pipeline register, that is, the DSM in the embodiment of the present invention is a traditional DSM;
when the input data are of multi-stage, the number of stages of the multi-stage pipeline register in the DSM in accordance with the embodiment of the present invention is the same as the number of stages of the input data, and by using the multi-stage pipeline register as an output, the timing of key sections such as adders can be improved without affecting the characteristics of the original transfer function, thereby increasing the sampling frequency of the circuit operations and improving the SNR performance;

When the input data are in a multi-parallel multi-stage data structure, a multi-stage pipeline register works as the multi-stage pipeline register of the first branch, its currently output data works as the first parallel branch; and the parallel processing unit performs parallel processing to obtain M-1 parallel branches (M is the number of parallel branches). After the parallel structure conversion, the result of the number of stages N of the input data being divided by the number of parallel branches is expressed as follows: the number of stages of the pipeline of each branch = N/the number of parallel branches M. For example, when N=4 and the number of parallel branches M=1, the number of stages of the pipeline of each parallel branch=4/1=4; for another example, when N=4 and the number of parallel branches M=4, the number of stages of the pipeline of each parallel branch=4/4=1; and for still another example, when N=4 and the number of parallel branches M=2, the number of stages of the pipeline of each parallel branch=4/2=2. In this case, the embodiment of the present invention also achieves higher sampling frequency through parallel processing on the basis of achieving the multi-stage pipeline register structure in the DSM, which greatly increases the sampling rate of the DSM, thus improving the SNR performance of the DSM and ensuring the DSM applications in the field of high-speed data processing.

All the embodiments shown in the above FIG. 3 to FIG. 7 take one-stage DSM structure as an example, the DSM provided in the embodiments of the present invention can be extended to a two, three and higher-stage structure, and the parallel can be used in several particular topological structures of the DSM circuit. The implementation way can be easily implemented by those skilled in the art on the basis of the DSM structural provided in the embodiments of the present invention, and it has many implementations which are not intended to limit the protection scope of the embodiments of the present invention. What is emphasized in the embodiments of the present invention is that, on the one hand, the DSM high-speed pipeline processing apparatus provided in the embodiments of the present invention achieves a multi-stage pipeline register structure in the DSM through the input data pre-processing unit and the advanced prediction unit, so as to improve the timing of key sections such as the adders without affecting the characteristics of the original transfer function, thereby increasing the sampling frequency of the circuit operations and improving the SNR performance; on the other hand, the structure of the DSM high-speed pipeline parallel processing apparatus provided in the embodiment of the present invention also achieve a higher sampling frequency on the basis of achieving the multi-stage pipeline register structure in the DSM, which greatly increases the sampling rate of the DSM, and also improves SNR performance of the DSM, so as to better ensure the DSM applications in the field of high speed data processing.

The embodiment of the present invention further provides a method for implementing the DSM modulation in accordance with an embodiment of the present invention, and as shown in FIG. 8, it comprises the following steps:
in step 800: it is to pre-process the input data.

This step specifically comprises: performing FIR processing on the input data, as well as performing delay and distribution processing on the input data, so that the input data produces a change from Z⁻¹ to Z^{-N} (N represents the number of stages), that is, it provides the foundation for the DSM high-stage implementation, that is, multi-stage implementation.

Wherein, the implementation ways for FIR processing as well as delay and distribution processing belong to the conventional techniques used by those skilled in the art and are not intended to limit the protection scope of the embodiments of the present invention, and are not further repeated herein. What is emphasized in this step is that, by pre-processing the input data, the input data produces a change from Z⁻¹ to Z^{-N} (N represents the number of stages), that is, it provides the foundation for the multi-stage implementation of the DSM.

In step 801: it is to predict the DSM modulation result according to the current data.

The step comprises: predicting the output value of the quantizer in the DSM ahead of time according to the data output by the register and the quantizer in the DSM as well as each intermediate-algebraic-transformed data stream during the pre-processing, and feeding it back as the input of the DSM. Wherein, the current data refers to the input of the advanced prediction unit, including the intermediate-algebraic-transformed u(n)∼u(n+(N-1)), as well as the current states y(n) and v(n) of the DSM register and quantizer. The obtained advanced prediction value refers to: the output vₓ(n) of the advanced prediction unit, and the next updated values y (n+1) and v (n+1) of the DSM quantizer and the register. The mathematical principles of the advanced prediction unit shown in FIG. 5 can be derived from the DSM mathematical relationship, and the implementations are conventional techniques used by those skilled in the art and are not repeated here.

In step 802: it is to perform a DSM modulation on the current data according to the pre-processed data and the prediction result.

In the method in accordance with an embodiment of the present invention, the input data can be single-stage data, at this time, the multi-stage pipeline register is a one-stage pipeline register, the DSM modulation way is consistent with the traditional DSM modulation way;
in the method in accordance with an embodiment of the present invention, the input data can be multi-stage data, at this time, the DSM modulation in step 302 uses the corresponding multi-stage pipeline register to achieve the modulation, and the number of stages of the multi-stage pipeline register is the same as the number of stages of the input data; at the same time, both the pre-processing and prediction steps comprise changing the input data from Z⁻¹ to Z⁻⁴, that is, multi-stage processing, whose implementations belong to the conventional techniques used by those skilled in the art and are not repeated herein. Thus, the method in accordance with the embodiments of the present invention improves the timing of key sections such as the adders without affecting the characteristics of the original transfer function, thereby increasing the sampling frequency of the circuit operations and improving the SNR performance.

In the method of the embodiment of the present invention, the input data can also be multi-parallel multi-stage data, at this time, the method in accordance with the embodiment of the present invention further comprises: performing parallel processing on the data output by the register and the quantizer in the DSM as well as the input data to obtain the parallel data output of the corresponding parallel input structure. At this time, the DSM modulation in step 302 uses the multi-stage pipeline register corresponding to the first branch to achieve the modulation, the data currently output by it are used as the first branch; the parallel processing unit performs parallel processing to obtain M-1 parallel branches (M is the number of parallel branches). After the parallel structure conversion, the number of stages of the pipeline of each branch=N/the number of parallel branches M. For example, when N=4 and the number of parallel branches M=1, the number of stages of the pipeline of each parallel branch=4/1=4; for another example, when N=4 and the number of parallel branches M=4, the number of stages of the pipeline of each parallel branch=4/4=1; for still another example, when N=4 and M=the number of parallel branches M=2, the number of stages of the pipeline of each parallel branch=4/2=2.

The embodiment of the present invention also achieves higher sampling frequency through parallel processing on the basis of achieving the multi-stage pipeline register structure in the DSM, which greatly increases the sampling rate of the DSM and improves the SNR performance of the DSM, thus ensuring the DSM applications in the field of high-speed data processing.

The above description is only preferred examples of the embodiments of the present invention and is not intended to limit the protection scope of the embodiments of the present invention. Any modifications, equivalents and improvements made within the spirit and principles of the embodiments of the present invention should be included within the protection scope of the embodiments of the present invention.

### Industrial Applicability

The technical scheme of the present application comprises: pre-processing inputted data; predicting a DSM modulation result according to the current data; finally, performing a DSM modulation on the current data according to the pre-processed data and the prediction result. An embodiment of the present invention pre-processes the inputted data and predicts the DSM modulation result, and achieves a multistage pipeline register structure in the DSM, thus improving the timing sequences of key sections such as the adders without affecting the characteristics of the original transfer function, thereby increasing the sampling frequency of circuit operations and thus improving the SNR performance.

The embodiment of the present invention makes the DSM provided in the embodiment of the present invention support parallel data modulation through parallel processing, and also achieves higher sampling frequency, greatly increases the DSM sampling rate and improves the SNR performance of the DSM on the basis of achieving the multi-stage pipeline register structure in the DSM, thus better ensuring the DSM applications in the field of high-speed data processing.

## Claims

1. A Delta Sigma Modulator (DSM), comprising an input data pre-processing unit, a DSM transfer function and quantization unit, and an advanced prediction unit, wherein,
the input data pre-processing unit is configured to: pre-process input data, output the pre-processed data to the DSM transfer function and quantization unit, and output each intermediate-algebraic-transformed data stream to the advanced prediction unit;
the DSM transfer function and quantization unit is configured to: receive data from the input data pre-processing unit and the advanced prediction unit, and perform the DSM function on the received data;
the advanced prediction unit is configured to: receive each intermediate-algebraic-transformed data stream from the input data pre-processing unit as well as data output from a register and a quantizer of the DSM transfer function and quantization unit; and according to the currently received data, predict an output value of the quantizer of the DSM transfer function and quantization unit ahead of time, and feed the output value back to the DSM transfer function and quantization unit.

2. The Delta Sigma Modulator of claim 1, wherein, the DSM further comprises a parallel processing unit, configured to: receive the input data as well as the data output from the register and the quantizer of the DSM transfer function and quantization unit; process the received data in parallel to obtain parallel outputs.

3. The Delta Sigma Modulator of claim 1 or 2, wherein, one is subtracted from a number of the intermediate-algebraic-transformed data streams and a number of stages of the input data respectively.

4. The Delta Sigma Modulator of claim 3, wherein, the DSM transfer function and quantization unit comprises adders, a multi-stage pipeline register, and a quantizer.

5. The Delta Sigma Modulator of claim 4, wherein, the input data are single-stage data, and the multi-stage pipeline register is a one-stage pipeline register;
or, the input data are multi-stage data, a number of stages of the multi-stage pipeline register is the same as the number of stages of the input data.

6. The Delta Sigma Modulator of claim 2, wherein, one is subtracted from the number of the intermediate-algebraic-transformed data streams and the number of stages of the input data respectively;
the DSM transfer function and quantization unit comprises adders, a multi-stage pipeline register, and a quantizer;
the input data are a plurality of parallel multi-stage data streams, the multi-stage pipeline register is a pipeline register in a first branch, and data currently output by the multi-stage pipeline register are taken as a first parallel branch;
the parallel processing unit processes in parallel to obtain M-1 parallel branches, wherein M is a number of parallel branches;
wherein, a number of stages of the pipeline in each branch is: a result of the number of stages of the input data N being divided by the number of parallel branches M.

7. The Delta Sigma Modulator of claim 3, wherein, a finite impulse response (FIR) filter is provided in the input data pre-processing unit.

8. The Delta Sigma Modulator of claim 1 or 2, wherein, the DSM is of a first-stage structure, or a two-stage structure, or three-stage or more than three-stage structure.

9. A method for a Delta Sigma modulator DSM performing modulation, comprising:
Pre-processing input data; predicting a DSM modulation result according to current data;
performing a DSM modulation on the current data according to the pre-processed data and the prediction result.

10. The method of claim 9, wherein, said predicting a DSM modulation result according to current data is: predicting an output value of a quantizer in the DSM ahead of time according to data output from a register and a quantizer in the DSM as well as each intermediate-algebraic-transformed data stream during the pre-processing, and feeding the output value back to the DSM.

11. The method of claim 10, wherein, one is subtracted from a number of the intermediate-algebraic-transformed data streams and a number of stages of the input data respectively.

12. The method of claim 11, wherein, the pre-processing comprises: FIR processing, delay and distribution processing.

13. The method of any one of claims 9∼12, wherein, the input data are single-stage data, a DSM modulation mode is a traditional DSM modulation mode.

14. The method of any one of claims 9∼12, wherein, the input data are multi-stage data; a number of stages of a multi-stage pipeline register in the DSM modulation is the same as the number of stages of the input data; and,
both the pre-processing and the prediction comprise multi-stage processing.

15. The method of any one of claims 9∼12, wherein, the input data are a plurality of parallel multi-stage data streams; the method further comprises: processing the data output from the register and the quantizer in the DSM as well as the input data in parallel;
the multi-stage pipeline register in the DSM modulation is a pipeline register in a first branch, data currently output by the multi-stage pipeline register are taken as a first parallel branch; M-1 parallel branches are obtained through processing in parallel, wherein M is a number of parallel branches;
wherein, a number of stages of the pipeline in each branch is: a result of the number of stages of the input data N being divided by the number of parallel branches M.
